# EUROPEAN PATENT SPECIFICATION

(11) **EP 0 966 048 B1**
(45) Date of publication and mention of the grant of the patent: **21.01.2004**
(21) Application number: 99830314.3
(22) Date of filing: 24.05.1999
(51) Int. Cl.: H01L 39/24

(54) **Non-magnetic metallic substrate for high-temperature superconductors and process for manufacture thereof**
Unmagnetisches metallisches Substrat für Hochtemperatur-Supraleiter und Verfahren zu dessen Herstellung
Substrat métallique non magnétique pour supraconducteurs à haute température et procédé de sa fabrication

(30) Priority: 15.06.1998 IT RM980395
(43) Date of publication of application: 22.12.1999
(73) Proprietor: ENEA ENTE PER LE NUOVE TECNOLOGIE, L'ENERGIA E L'AMBIENTE, 00196 Roma (IT)
(72) Inventor: Petrisor, Traian, 00044 Frascati RM (IT); Boffa, Vincenzo, 00144 Rome (IT); Ceresara, Sergio, 55100 Lucca (IT)
(74) Representative: Tonon, Gilberto

(56) References cited:
- US-A- 5 741 377
- PETRISOR T ET AL: "Development of biaxially aligned buffer layers on Ni and Ni-based alloy substrates for YBCO tapes fabrication" 1998 APPLIED SUPERCONDUCTIVITY CONFERENCE, PALM DESERT, CA, USA, 13-18 SEPT. 1998, vol. 9, no. 2, pt.2, pages 2256-2259, XP002116557 IEEE Transactions on Applied Superconductivity, June 1999, IEEE, USA ISSN: 1051-8223

## Description

The present invention relates to a nonmagnetic metallic substrate of cubic-shaped texture for the manufacture of high-temperature superconducting tapes, and to the production process thereof. According to the invention, such tape consists of a flexible tape realised with a nonmagnetic Nickel-Vanadium metallic alloy, having a cubic-shaped texture from a crystallographic point of view.

The substrates most commonly used for superconductors consist of pure Ni (purity >99.9%). This is so because in pure Ni the cubic-shaped texture can easily be induced with a thermo-mechanical treatment. Further, Ni possesses suitable chemical and mechanical properties, having a high oxidation resistance and a sufficient flexibility even after a thermal recrystallization treatment.

The main drawback of the Ni lies in its being ferromagnetic, with a Curie temperature of 358°C, and therefore well over the operative temperature of the superconducting tapes (approx. -195°C).

A superconducting tape onto a ferromagnetic metallic substrate would have high losses under alternating current due to the magnetisation energy of the substrate itself. Accordingly, an energy dissipation would follow, with the consequent significant decrease of the tape electrical properties. In the case of application in high magnetic fields (e.g. magnetic storage accumulators, superconducting magnets, etc.) the magnetic field-forces would limit the use of the cable in this field.

Another metal that can easily be provided with a cubic-shaped texture is copper. It is not ferromagnetic, but its mechanochemical properties, particularly its low resistance to oxidation, do not allow an easy use thereof.

The Ni-V tape according to the invention is a support suitable for the manufacture of high critical temperature superconducting tapes based on thick biaxially-oriented films, in particular of the superconductor YBaCu₃O₇ₓ (YBCO) or ReBa₂Cu₃O₇₋ₓ, wherein Re are rare earths. The Ni-V tape maintains the chemical, mechanical and crystalline properties of the Ni tape, having the further advantage that its Curie temperature can be controlled through the vanadium concentration. For instance, for an alloy having a 12% of vanadium atoms the Curie temperature is of approximately 10 K, well below the operative temperature of the superconductor cable. In short, the Ni-V tape possesses the desired properties of the Ni-Cu tapes. In this sense, the Ni-V tape represents an ideal metallic substrate for the epitaxial growth of the thick superconducting films for the manufacture of the second generation SAT tapes.

The superconductor cables based on thick YBCO films deposited on flexible metallic substrates represent the second generation of superconducting tapes having a high critical temperature for applications on a large scale.

A method for the preparation of such tapes foresees the use of metallic supports of cubic-shaped texture having suitable magnetic, mechanic, thermal and chemical characteristics. To date, the support used has been the nickel; such metal possesses the above mentioned properties, save the fact that it is ferromagnetic at the operative temperatures of the superconducting cable (64-80K). The main drawback of the nickel support lies in this latter property, as it limits the potential applications of the superconductor YBCO cable. Another metal, having crystalline and magnetic characteristics suitable for such applications, is the copper, that however possesses utterly unsuitable mechanochemical properties.

According to the present invention a tape-shaped substrate base is provided, suitable for the realisation of superconducting tapes possessing the properties described in the characterising part of the product claims.

Further according to the present invention, a process for the manufacture of a Nickel-Vanadium tape of a cubic-shaped texture is provided, using the steps as disclosed in the characterising part of the process claims.

The present invention will be disclosed hereinafter with reference to one of its presently preferred embodiments, reported by way of example and not for limiting purposes, and making reference to the figures of the annexed drawings, wherein:
figure 1 shows the magnetic characteristics of a solid Ni-V solution: Curie temperature (temperature below which the material is ferromagnetic) of the nickel, with the increase of the concentration;
figure 2 shows an X-ray (θ-2θ) diffraction pattern for a Ni-V sample subjected to a thermo-mechanical treatment;
figure 3 shows polar figures of the planes (111) and (200) obtained by X-ray measurement for a Ni-V sample subjected to a thermo-mechanical treatment;
figure 4 shows an X-ray (θ-2θ) diffraction pattern for a Ni sample subjected to a thermo-mechanical treatment;
figure 5 shows polar figures of the planes (111) and (200) obtained by X-ray measurements for a Ni sample subjected to a thermo-mechanical treatment.

According to the present invention a flexible metallic substrate is provided, having a preferential orientation (100)[001] and suitable magnetic, chemical, mechanical properties for the manufacture of superconducting tapes of high critical temperature: for a cubic-shaped texture (100)[001] the grains of which the material is composed have the crystalline plane (100) parallel to the rolling surface and the crystalline direction [100] parallel to the rolling direction, i.e. the grains are biaxially oriented.

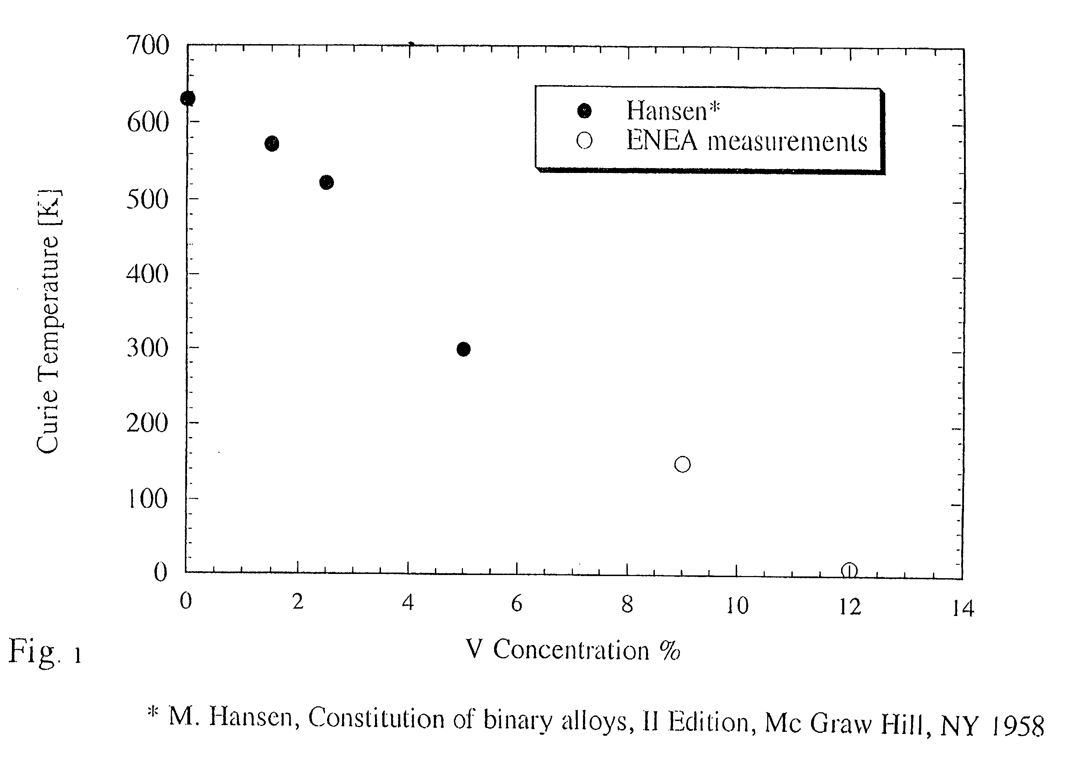

Such support consists of a solid Ni-V solution, with the atomic concentration of the Vanadium in the range 8-12%. The vanadium lowers the Curie temperature (temperature below which the material is ferromagnetic) of the nickel, with the increasing of the concentration thereof, as shown in figure 1. Moreover, being a solid solution, it maintains to a great extent the crystalline and chemical properties of the nickel, improving the mechanical ones thereof. For the sake of simplicity, the solid Ni-V solution will be referred to hereinafter as Ni-V alloy.

The Ni-V metallic tape is obtained by thermo-mechanical treatments, as will be disclosed hereinafter. From a crystallographic point of view, it exhibits a cubic-shaped texture (100)[001], as can be derived from the polar figures of the planes (111) and (200).

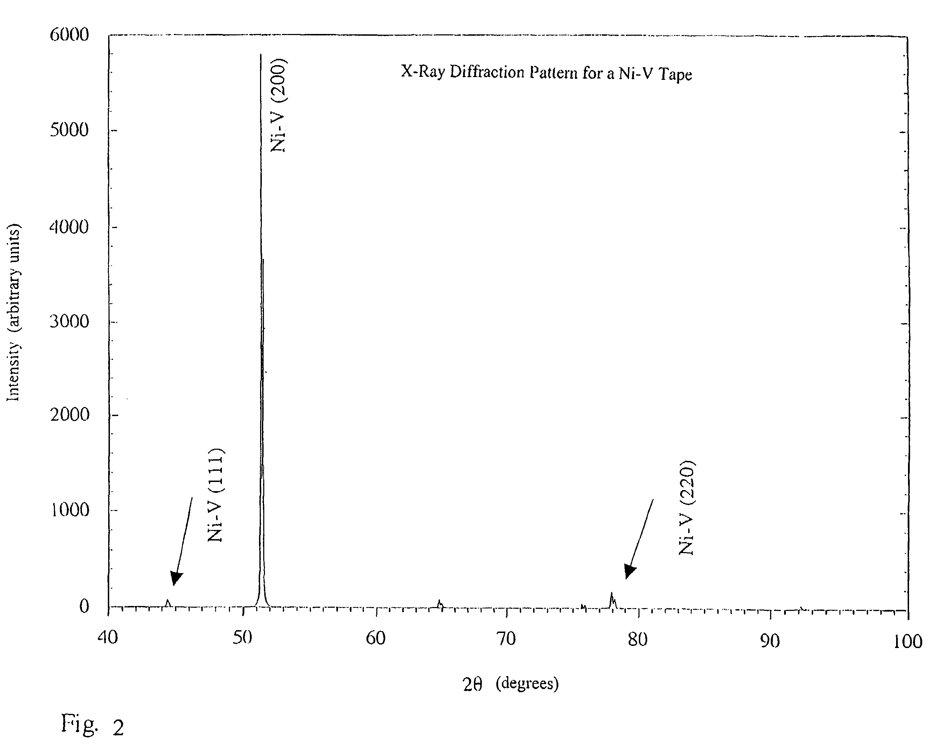

In general, in the X-ray spectrum (θ-2θ) only those peaks related to the planes parallel to the diffractometer plane are highlighted, overlapping in the case at issue to the rolling plane (tape surface). In figure 2 only those peaks related to the parallel planes (200) and (400) are present: this means that all the grains are lined up with the plan (100) parallel to the surface ("off-plane" orientation).

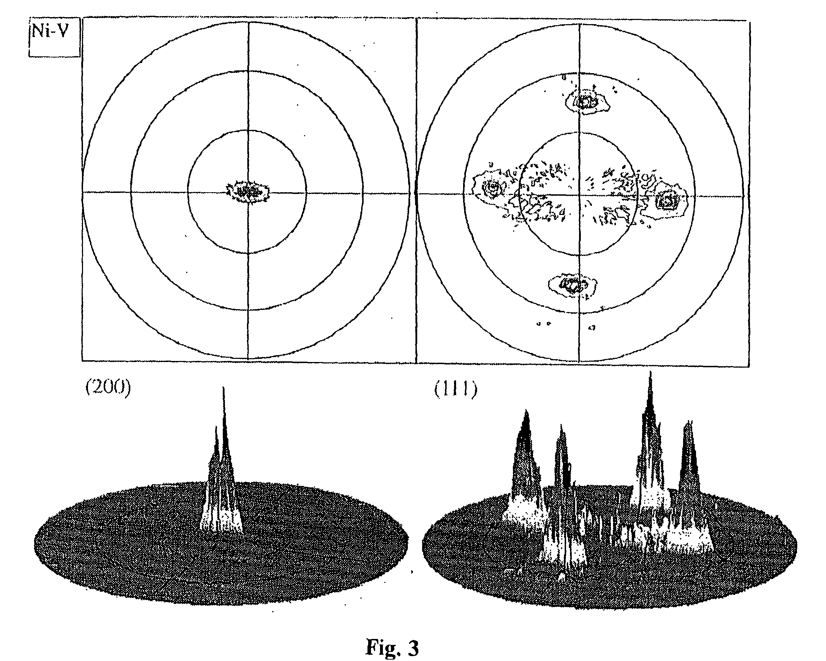

Concerning the polar figures, in general they provide information related to the distribution of the grain orientation with respect to an arbitrary direction; in the case at issue such direction is the rolling direction: for a non orientated polycrystalline sample the poles are uniformly distributed onto the figure plane, while figure 3 clearly indicates that the tape poles according to the invention are well localised, their position overlapping with that of a centred-face cubic crystal (FCC). This means that all the tape grains are oriented with the direction [100] parallel to the rolling direction ("in-plane" orientation).

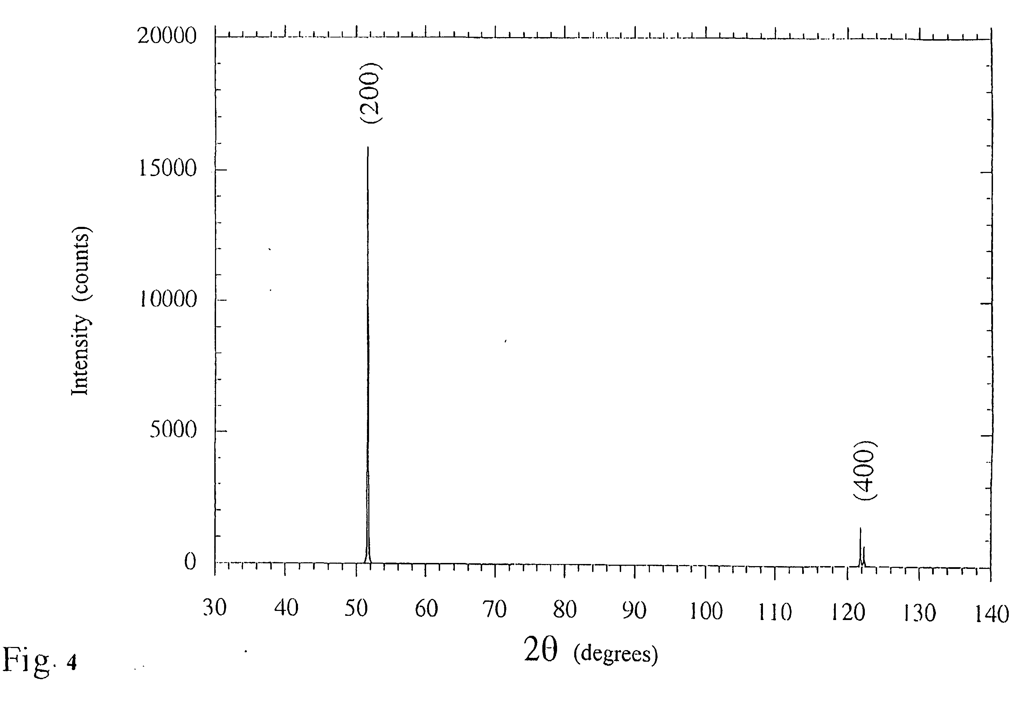

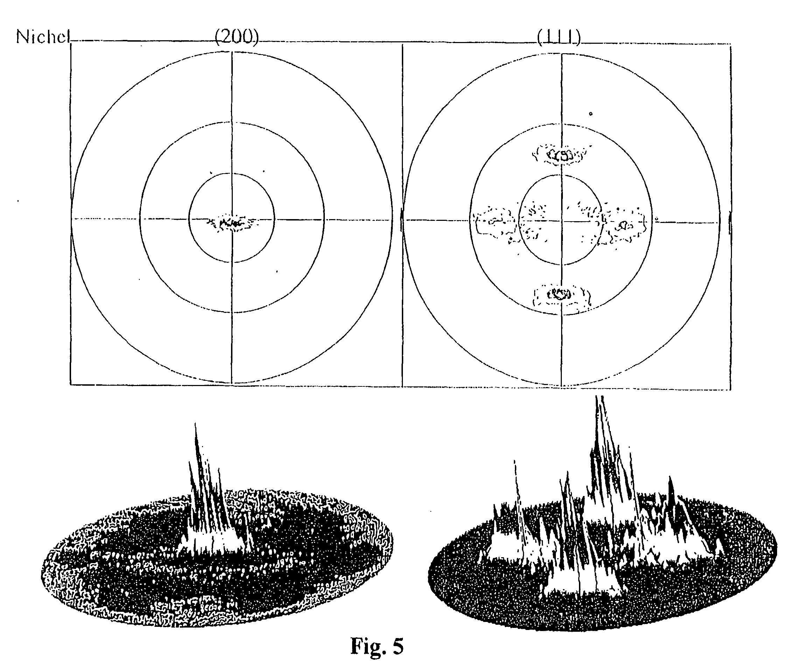

The measurements reported in figures 2 and 3 also show that the Ni-V alloy has a texture comparable to that of the pure metals as nickel and copper. In comparison, the spectrum θ-2θ and the polar figures for a Nickel support are represented in figures 4 and 5, respectively. The process according to the invention for the manufacture of the Ni-V tape provided with a cubic-shaped texture foresees the following steps:
- during the first step the preparation of a Nickel-Vanadium solid solution takes place, with the atomic concentration in the range 8-12%; the Ni and V ingots are placed in a smelter (arc furnace, plasma, etc.), and the smelting process takes place in a controlled atmosphere, with a water-cooled ingot mold in order to avoid a contamination of the alloy by the ingot mold material, typically consisting of copper;
- in the second step the material is mechanically subdivided by machining in bars (e.g., approximately of a 4 x 4 mm² section and approx. of a 10 cm length); the bars are treated at 900°C for 1 hour to eliminate the work hardening effects;
- the third step foresees the cold-rolling of the bars with a consequent thickness reduction of over 95%; thus yielding thicknesses thinner than 200 µm;
- the fourth and final step consists of a thermal recrystallization treatment of the tape, preferably in an high-vacuum furnace (approx. 5x10⁻⁷ Torr) to avoid the tape oxidation, at temperatures typically comprised in the range 800-1000°C for at least one hour. Preferably, the upward and downward thermal ramps have a speed of approx. 1000°C/hour

The tape thus obtained exhibits a surface having a cleaning rate sufficient to be used as substrate for the deposition of the YBCO superconductor, with no need of further special cleaning processes.

Therefore, the main innovation of the invention lies in the decrease of the Curie temperature, by the alloying of nickel with nonmagnetic elements (vanadium), while maintaining all the properties of the analogous nickel support.

### Industrial usefulness

The invention is needed for the manufacture of thick films provided with a crystalline structure. The present nonmagnetic metallic substrate of cubic-shaped texture was developed in particular for the epitaxial growth of thick films (d≅1ö5 µm) of ReBa₂Cu₃O₇₋ₓ (Re = Y, Nd, Sm, etc.) for the manufacture of tapes superconductor at a high temperature: through the epitaxial growth process, the cubic-shaped texture of the substrate is passed to the superconducting film. Thus, a superconducting film with a controlled grain edge is obtained, that can carry a current density of approximately 10⁶ A/cm² at the liquid nitrogen temperature (77 K) and in a null magnetic field. Superconducting films with a controlled grain edge deposited onto a substrate are called "second-generation high temperature superconducting tapes (SAT)".

The potential applications of the second-generation SAT tapes are several: superconducting magnets, power transmission lines, superconducting transformers, short-circuit current limiters, magnetic storage accumulators (SMES), etc. The "quasi-crystal" metallic substrate might also constitute an alternative to the single-crystal substrates for the growth of oriented ferroelectric films like PbTiO₃ and PbZrₓTi₁₋ₓO₃, and films of ferromagnetic materials.

Therefore, the importance of the invention lies essentially in the possibility of disposing of a nonmagnetic metallic support provided with a crystalline structure and with great potential, in particular in the manufacture of superconducting tapes of high critical temperature, piezoelectric and ferroelectric films.

## Claims

1. A nonmagnetic metallic tape or substrate, **characterised in that** it consists of a Nickel-Vanadium alloy with an atomic concentration percentage of vanadium in the range 8-12%, and **in that** said alloy possesses a cubic-shaped texture and a Curie temperature lower than the operative temperature of the so-called high temperature superconductors.

2. The nonmagnetic metallic tape or substrate according to claim 1, **characterised in that** it constitutes a support for the so-called high temperature superconductors.

3. The tape or substrate according to claim 2, **characterised in that** said high-temperature superconductors are of the type ReBCu₃O₇₋ₓ where Re indicates rare earths.

4. The tape or substrate according to claim 2, **characterised in that** said high-temperature superconductor consists of YBa₂Cu₃O₇₋ₓ.

5. The tape or substrate according to claim 1, **characterised in that** it possesses a quasi-crystalline structure suitable for the growth of piezoelectric or oriented ferroelectric films, of the titanate class, such as PbTiO₃ and PbZrₓTi₁₋ₓO₃.

6. A process for the manufacture of the tape or of the Ni-V substrate provided with a cubic-shaped texture, according to one or more of the preceding claims, foreseeing the following steps:
a) a first step wherein the preparation of a solid Nickel-Vanadium solution takes place, with the atomic concentration in the range 8-12%; the Ni and V ingots being placed in a smelter (arc furnace, plasma, etc.), and the smelting process taking place in a controlled atmosphere, with a water-cooled ingot mold in order to avoid a contamination of the alloy by the ingot mold material, typically consisting of copper;
b) a second step wherein the material is mechanically subdivided by machining in bars approximately of a 4 x 4 mm² section and approx. of a 10 cm length); the bars being treated for at 900°C for 1 hour to eliminate the work hardening effects;
c) a third step entailing the cold-rolling of the bars with a consequent thickness reduction of over 95%; thus yielding thicknesses thinner than 200 µm;
d) a fourth and final step consisting of a thermal recrystallization treatment of the tape preferably in an high-vacuum furnace (approx. 5x10⁻⁷ Torr) to avoid the tape oxidation, at temperatures typically comprised in the range 800-1000°C for at least one hour, the upward and downward thermal ramps preferably having a rate of approx. 1000°C/hour.

## Patentansprüche

1. Nichtmagnetisches metallisches Band oder Substrat, **dadurch gekennzeichnet, dass** es aus einer Nickel-Vanadium-Legierung mit einem Atomkonzentrations-Anteil von Vanadium im Bereich 8-12% besteht, und dass die Legierung eine würfelförmige Textur sowie eine Curie-Temperatur unter der Betriebstemperatur der sogenannten Hochtemperatur-Supraleiter aufweist.

2. Nichtmagnetisches metallisches Band oder Substrat nach Anspruch 1, **dadurch gekennzeichnet, dass** es einen Träger für die sogenannten Hochtemperatur-Supraleiter bildet.

3. Band oder Substrat nach Anspruch 2, **dadurch gekennzeichnet, dass** der Hochtemperatur-Supraleiter vom Typ ReBCu₃O₇₋ₓ ist, wobei Re Seltenerden anzeigt.

4. Band oder Substrat nach Anspruch 2, **dadurch gekennzeichnet, dass** der Hochtemperatur-Supraleiter aus Yba₂Cu₃O₇₋ₓ besteht.

5. Band oder Substrat nach Anspruch 1, **dadurch gekennzeichnet, dass** es eine quasi-kristalline Struktur besitzt, die für das Wachstum piezoelektrischer oder orientierter ferroelektrischer Filme der Titanat-Klasse, wie beispielsweise PbTiO₃ und PbZrₓTi₁₋ₓO₃, geeignet ist.

6. Prozess zum Herstellen des Bandes bzw. des mit einer würfelförmigen Textur versehenen Ni-V-Substrats nach einem oder mehreren der vorangehenden Ansprüche, der die folgenden Schritte vorsieht:
a) einen ersten Schritt, in dem die Erzeugung einer festen Nickel-Vanadium-Lösung stattfindet, wobei die Atomkonzentration im Bereich 8-12% liegt und die Ni- und V-Blöcke in einen Schmelzofen (Lichtbogenofen, Plasma usw.) eingelegt werden und der Schmelzprozess in einer gesteuerten Atmosphäre mit einer wassergekühlten Blockform stattfindet, um eine Verunreinigung der Legierung durch das Blockformmaterial zu vermeiden, das normalerweise aus Kupfer besteht;
b) einen zweiten Schritt, in dem das Material durch maschinelle Bearbeitung mechanisch in Stäbe zerteilt wird, die einen Querschnitt von ungefähr 4 x 4 mm² und eine Länge von ungefähr 10 cm haben, wobei die Stäbe eine Stunde lang bei 900°C behandelt werden, um die Auswirkungen der Umformverfestigung zu beseitigen;
c) einen dritten Schritt, der das Kaltwalzen der Stäbe mit einer dadurch bewirkten Dickenverringerung von über 95% mit sich bringt, so dass Dicken von weniger als 200 µm entstehen;
d) einen vierten und abschließenden Schritt, der aus einer thermischen Rekristallisationsbehandlung des Bandes vorzugsweise in einem Hochvakuumofen (ungefähr 5 x 10⁻⁷ Torr), um die Bandoxidation zu vermeiden, bei Temperaturen, die normalerweise im Bereich 800-1000°C liegen, über wenigstens eine Stunde besteht, wobei die thermischen Aufwärts- und Abwärts-Rampen vorzugsweise eine Rate von ungefähr 1000°C/h haben.

## Revendications

1. Ruban ou substrat métallique non magnétique, **caractérisé en ce qu'**il consiste en un alliage de nickel - vanadium avec un pourcentage de concentration atomique de vanadium dans la plage de 8-12% et **en ce que** ledit alliage possède une texture de forme cubique et une température Curie inférieure à la température opérante des supraconducteurs dits à hautes températures.

2. Ruban ou substrat métallique non magnétique selon la revendication 1, **caractérisé en ce qu'**il constitue un support pour les supraconducteurs dits à hautes températures.

3. Ruban ou substrat selon la revendication 2, **caractérisé en ce que** les supraconducteurs dits à hautes températures sont du type ReBCu₃O₇₋ₓ où Re désigne les terres rares.

4. Ruban ou substrat selon la revendication 2, **caractérisé en ce que** le supraconducteur dit à hautes températures consiste en Yba₂Cu₃O₇₋ₓ.

5. Ruban ou substrat selon la revendication 1, **caractérisé en ce qu'**il possède une structure quasi cristalline apte à la croissance de films piézoélectriques ou ferro - électriques orientés, de la classe du titanate, telle que PbTiO₃ et PbZrₓTi₁₋ₓO₃ .

6. Procédé pour la fabrication du ruban ou du substrat Ni - V doté d'une texture de forme cubique selon une ou plusieurs des revendications précédentes, en prévoyant les étapes suivantes :
a) une première étape dans laquelle s'effectue la préparation d'une solution nickel - vanadium solide avec une concentration atomique dans la plage de 8-12%; les lingots Ni et V étant placés dans un four de fusion (four à arc, plasma, etc.), et le procédé de fusion s'effectuant dans une atmosphère contrôlée, avec une lingotière refroidie par eau pour éviter une contamination de l'alliage par le matériau de la lingotière, typiquement consistant en cuivre;
b) une seconde étape dans laquelle le matériau est subdivisé mécaniquement par usinage en barres d'environ 4 x 4 mm² de section et d'environ 10 cm de longueur); les barres étant traitées à 900°C pendant 1 heure pour éliminer les effets de durcissement de l'usinage;
c) une troisième étape impliquant le laminage à froid des barres avec une réduction importante de l'épaisseur de plus de 95%; donnant ainsi des épaisseurs inférieures à 200 µm;
d) une quatrième et dernière étape consistant en un traitement de recristallisation thermique du ruban de préférence dans un four de vide poussé (environ 5 x 10⁻⁷ Torr) pour éviter l'oxydation du ruban, à des températures typiquement comprises dans la plage de 800 - 1000°C pendant au moins une heure, les rampes thermiques montantes et descendantes ayant de préférence une allure d'environ 1000°C/heure.
